Europäisches Patentamt

European Patent Office

Office européen des brevets

(19)

(11) Numéro de publication: **0 248 713 B1**

## FASCICULE DE BREVET EUROPEEN

(12)

(45) Date de publication de fascicule du brevet:
**08.05.91**

(51) Int. Cl.⁵: **H03G 9/18**

(21) Numéro de dépôt: **87401191.9**

(22) Date de dépôt: **27.05.87**

(54) Dispositif de réduction du bruit de fond dans une chaîne électroacoustique.

(30) Priorité: **30.05.86 FR 8607813**

(43) Date de publication de la demande:
**09.12.87 Bulletin 87/50**

(45) Mention de la délivrance du brevet:
**08.05.91 Bulletin 91/19**

(84) Etats contractants désignés:
**AT BE CH DE ES GB GR IT LI LU NL SE**

(56) Documents cités:
**US-A- 3 757 254**
**US-A- 3 784 749**
**US-A- 3 930 208**

(73) Titulaire: **ELISON**
**112 Rue de Tocqueville**
**F-75017 Paris(FR)**

(72) Inventeur: **Imreh, Miklos**
**Route des Hautes Auges**
**F-78112 Fourqueux(FR)**

(74) Mandataire: **Thévenet, Jean-Bruno et al**
**Cabinet BEAU DE LOMENIE 55 rue d'Amsterdam**
**F-75008 Paris(FR)**

## Description

La présente invention a pour objet un dispositif de réduction du bruit de fond dans une chaîne électroacoustique d'enregistrement ou de reproduction.

On connait déjà différents types de dispositifs réducteurs de bruit de fond visant à atténuer le bruit de fond dû à la transmission ou au stockage d'informations (voir par exemple US-A 3784749).

Selon un premier type de dispositif réducteur de bruit de fond, tel que par exemple l'un des systèmes connus sous les dénominations Dolby, Dbx, il est nécessaire de réaliser un codage d'informations au départ, à l'enregistrement des informations et de réaliser un décodage des informations à l'arrivée lors de la restitution des informations. Le codage peut être réalisé sous la forme d'une compression du signal tandis que le décodage correspond alors à une expansion du signal. Dans un tel système, il est indispensable de disposer de deux appareils complémentaires pour réaliser une amélioration du rapport signal/bruit. Par ailleurs, ce système est inopérant pour réduire, lors de la reproduction, le bruit de fond dû à des enregistrements de mauvaise qualité ou altérés qui n'ont pas fait l'objet d'un codage approprié lors de l'enregistrement, par exemple parce qu'ils sont trop anciens.

Selon un autre type de dispositif réducteur de bruit, il est utilisé des filtres passe-bande suivis de portes de suppression de bruit qui, en l'absence de signal utile, coupent l'ensemble des informations disponibles en entrée. Ce système ne réalise donc pas une réduction du bruit mais une suppression qui peut s'avérer préjudiciable également pour le signal d'information lui-même.

D'autres types de réducteurs de bruit, utilisent des amplificateurs à gain variable qui assurent un traitement global de l'information, ce qui conduit à des dispositifs peu performants ou délicats à réaliser.

On a également proposé de réaliser un système de réduction du bruit de fond dans lequel la bande de fréquences audio ou vidéo considérée est découpée en tranches à l'aide d'une batterie de filtres passe-bande disposés en parallèle et recevant chacun le signal d'entrée dont le rapport signal/bruit est à améliorer. Chaque filtre est associé à un limiteur compresseur à seuil programmable pour ne laisser passer un signal utile que si, dans la bande-passante considérée, le niveau de signal dépasse un seuil prédéterminé. Un tel système implique toutefois de disposer d'un grand nombre de filtres dont les bande-passantes se recoupent de façon précise, ce qui accroît le coût et la complexité du système.

La présente invention vise à remédier aux inconvénients précités et à permettre la réalisation d'un dispositif réducteur de bruit qui soit à la fois bon marché, efficace, utilisable sans codage du signal et de conception modulable.

Ces buts sont atteints grâce à un dispositif de réduction du bruit de fond dans une chaîne électroacoustique d'enregistrement ou de reproduction comprenant au moins un circuit de correction interposé dans la chaîne électroacoustique et comportant un filtre passe-bande recevant un signal d'entrée, un circuit limiteur-compresseur connecté en sortie du filtre passe-bande, un circuit de détection du seuil connecté en sortie du circuit limiteur-compresseur et rebouclé sur ledit circuit limiteur-compresseur pour n'autoriser une compression par ledit circuit limiteur-compresseur du signal issu du filtre passe-bande que si le signal d'entrée dépasse un seuil prédéterminé et un circuit sommateur-inverseur auquel est appliqué d'une part le signal issu du circuit limiteur-compresseur et d'autre part, par l'intermédiaire d'un circuit inverseur, le signal d'entrée apliqué à l'entrée du filtre passe-bande.

Le dispositif selon l'invention peut ne comprendre qu'un seul étage pour éliminer du bruit lié à une bande de fréquences précise.

Toutefois, le dispositif peut avantageusement comprendre plusieurs circuits de correction montés en cascade dans la chaîne électroacoustique et comprenant des filtres passe-bande dont les bandes pasantes sont différentes mais ne se recoupent pas nécessairement.

Dans ce cas, il est préférable que les bandes-passantes des filtres passe-bande des circuits de correction montés successivement en cascade soient croissantes.

Selon une caractéristique de la présente invention, le circuit de détection de seuil comprend un amplificateur linéaire à gain variable connecté en sortie du circuit limiteur-compresseur et un circuit de référence de tension.

De façon plus particulière, le circuit de détection de seuil comprend en outre un circuit de retard pour effectuer la commande du circuit limiteur-compresseur avec une constante de temps prédéterminé adaptée à la bande-passante du filtre.

Selon un mode particulier de réalisation le circuit de détection de seuil comprend un circuit doubleur de tension connecté en sortie de l'amplificateur linéaire à gain variable et le circuit de référence de tension comprend au mons une diode Zener.

Selon une autre caractéristique avantageuse, le circuit limiteur-compresseur comprend un amplificateur opérationnel et un transistor à effet de champ V-MOS commandé par le circuit de détection de seuil pour court-circuiter sélectivement l'entrée de l'amplificateur opérationnel lorsque le circuit de détection de seuil détacte le dépassement d'un seuil prédéterminé de tension.

D'autres caractéristiques et avantages de l'invention ressortiront de la description suivante d'un mode particulier de réalisation, donné à titre d'exemple, en référence aux dessins annexés, sur lesquels:

- la figure 1 est un schéma bloc montrant un circuit de correction incorporé dans un réducteur de bruit conforme à l'invention,
- la figure 2 est un schéma plus détaillé d'un exemple de réalisation du circuit de correction de la figure 1,
- la figure 3 présente des diagrammes montrant l'évolution d'une tension de compensation $V_L$ en fonction de la tension d'entrée $V_e$ pour des valeurs maximum et minimum du gain de l'amplificateur linéaire à gain variable du circuit de correction des figures 1 et 2.
- la figure 4 présente des diagrammes montrant l'évolution de la tension de sortie $V_S$ en fonction de la tension d'entrée $V_e$ pour des valeurs maximum et minimum du gain de l'amplificateur à gain variable du circuit de correction des figures 1 et 2, et
- la figure 5 présente des courbes donnant l'évolution de la tension de sortie $V_S$ en fonction de la fréquence f pour différents niveaux du signal d'entrée.

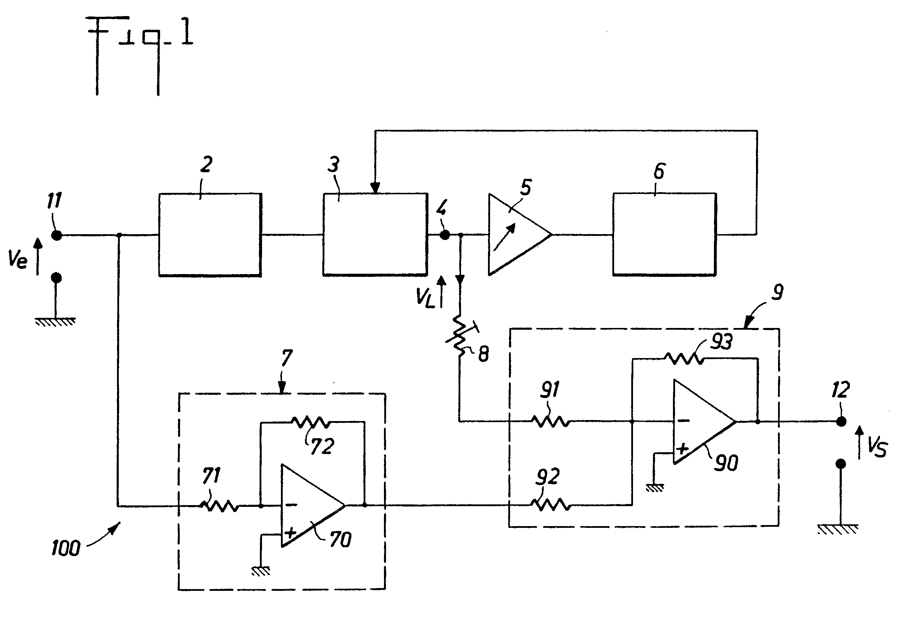

On a représenté sur la figure 1 le schéma d'ensemble d'un circuit de correction 100 qui assure le filtrage dynamique d'un signal d'entrée $V_e$ appliqué à l'entrée 11 du circuit 100 pour fournir à la sortie 12 du circuit de correction 100 un signal de tension de sortie $V_S$ dont le rapport signal/bruit est amélioré dans une bande de fréquences prédéterminée.

Le circuit de correction 100 agit ainsi dans une bande de fréquences limitée centrée sur une fréquence $f_n$ prédéterminée. Plusieurs circuits de correction 100 agissant chacun dans une bande de fréquences limitée qui peut, ou non, se recouper avec la bande de fréquences d'autres circuits de correction, peuvent être montés en cascade les uns à la suite des autres pour améliorer le rapport signal/bruit sur une plage de fréquences plus étendue. Dans ce cas, il est préférable que les circuits de correction agissant dans les fréquences basses et présentant les bandes de fréquences les plus étroites soient disposés en amont des circuits de correction agissant dans les fréquences élevées et présentant des bandes de fréquences plus larges.

A titre d'exemple, un dispositif réducteur de bruit selon l'invention peut comprendre cinq ou six étages de correction 100 en cascade, les deux premiers étages agissant dans le bas du spectre des fréquences pour réduire les perturbations créées à la fréquence d'alimentation du réseau (50 ou 60 Hz) ou correspondant à des harmoniques de celle-ci, et les trois ou quatre étages de correction suivant agissant dans le haut du spectre des fréquences dans une plage allant approximativement de 3 à 15 kHz pour éliminer le souffle superposé au signal utile

Le dispositif réducteur de bruit selon l'invention peut naturellement fonctionner avec un plus grand nombre de circuits de correction en cascade ou au contraire avec un seul circuit de correction s'il s'agit d'effectuer une correction autour d'une fréquence bien déterminée. Le dispositif présente l'avantage d'être facilement extensible, du fait de sa conception modulable, et d'être relativement bon marché puisque les différents circuits de correction ou modules présentent la même structure d'ensemble. Surtout, le dispositif selon l'invention permet de réduire plus ou moins le niveau de bruit sur l'ensemble du spectre en fonction du nombre d'étages de correction, mais, quel que soit le nombre d'étages, le signal utile est intégralement conservé.

On décrira maintenant de façon plus particulière le circuit de correction 100 de la figure 1. Le signal d'entrée $V_e$ disponible sur la bonne d'entrée 11 est appliqué d'une part à un filtre passe-bande 2 et, d'autre part, par l'intermédiaire d'une résistance 71, à l'entrée inverseuse d'un amplificateur opérationnel 70 qui constitue, avec la résistance 71 et une résistance de bouclage 72 un circuit inverseur 7. La sortie de l'amplificateur inverseur 7 est appliquée à l'une des entrées d'un amplificateur-sommateur 9.

La sortie du filtre passe-bande 2 est reliée à l'entrée d'un circuit limiteur-compresseur 3 dont la sortie 4 est elle-même connectée à une deuxième entrée du circuit sommateur 9 par l'intermédiaire d'un élément 8 d'ajustement du niveau de la tension $V_L$, de même signe que la tension d'entrée $V_e$, disponible à la sortie 4 du circuit limiteur-compresseur 3. La sortie 4 du circuit limiteur-compresseur 3 est en outre reliée à l'entrée d'un amplificateur linéaire 5 à gain ajustable dont la sortie est appliquée à un circuit de détection de seuil 6 qui commande lui-même le fonctionnement du circuit limiteur-compresseur 3.

L'amplificateur-sommateur 9 comprend un amplificateur opérationnel 90 dont l'entrée inverseuse est reliée à la sortie par une résistance de bouclage 93 et reçoit les signaux issus de la sortie 4 du limiteur compresseur 3 et la sortie de l'amplificateur inverseur 7 par l'intermédiaire de résistances 91, 92 respectivement.

Le fonctionement du circuit de correction 100 de la figure 1 est le suivant.

L'amplificateur linéaire à gain variable 5 rebouclé par le circuit de détection de seuil et de constante de temps 6 sur le limiteur-compresseur 3 présente un gain ajustable entre une valeur mini-

male $G_{vmin}$ et une valeur maximale $G_{vmax}$. Le circuit détecteur de seuil 6 étant lui-même réglé pour réagir lorsque la tension en sortie de l'amplificateur à gain variable 5 dépasse un niveau ou seuil prédéterminé, le fonctionnement du limiteur-compresseur 3. sera déterminé par la valeur du gain $G_v$ de l'amplificateur 5 qui définira un seuil effectif de déclenchement du fonctionnement du limiteur-compresseur 3. En pratique, si $V_b$ représente la tension du bruit de fond à l'entrée du limiteur compresseur 3, le gain $G_v$ de l'amplificateur 3 sera réglé de telle manière que le limiteur-compresseur 5 ne joue un rôle de compression qui si la tension à la sortie du filtre 2 dépasse la valeur $V_b$. Ainsi, pour tous les signaux $V_e$ d'entrée tels que, dans la bande passante du filtre 2, le niveau en sortie de ce filtre est inférieur à un seuil prédéterminé $V_b$, le limiteur-compresseur conserve un gain égal à 1 et fournit en sortie au point 4 un signal de tension $V_L$ correspondant sensiblement à la tension d'entrée du limiteur-compresseur 3 et de même signe que celle-ci. Le circuit sommateur 9 réalise alors l'addition du signal d'entrée $V_e$ inversé et du signal $V_L$, en inversant le résultat de cette addition, c'est-à-dire délivre un signal de sortie $V_S$ équivalent au signal d'entrée Ve mais diminué du signal $V_L$ dans la bande-passante du filtre 2. Il y a donc bien eu diminution du bruit dans cette bande passante.

En revanche, lorsque la tension à l'entrée dulimiteur-compresseur 3 dépasse le niveau $V_b$, le limiteurcompresseur 3 présente un coefficient d'atténuation important et ne délivre plus au point 4 qu'un signal $V_L$ de niveau négligeable plafonné au niveau $V_G$. Le signal $V_S$ en sortie de l'amplificateur-sommateur 9 correspond alors pratiquement au signal Ve appliqué sur la borne d'eentrée 11 du circuit de correction 100, diminué d'une valeur de correction $V_L$ qui ne représente qu'une faible proportion de la valeur $V_e$.

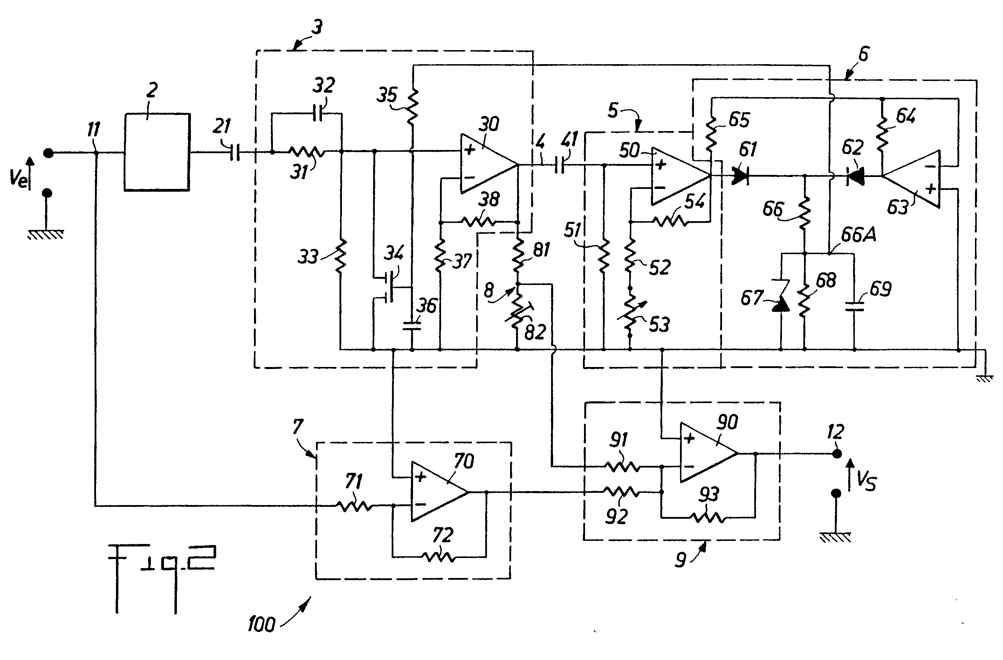

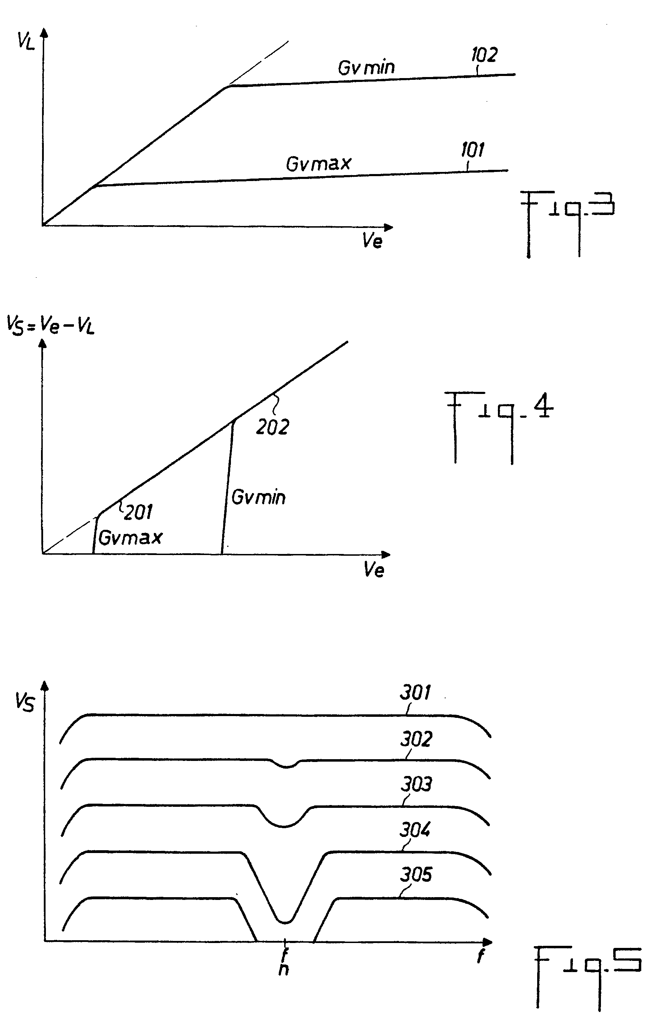

Les figures 3 et 4 montrent l'allure des courbes représentant d'une part la tension de correction $V_L$ à la sortie 4 du limiteur-compresseur 3 et d'autre part la tension de sortie $V_S$ à la sortie 12 du dispositif de correction 100 en fonction de la tension d'entrée Ve pour deux valeurs de réglage $G_{vmax}$ (courbes 101 et 201) et $G_{vmin}$ (courbes 102 et 202) de l'amplificateur à gain variable 5 rebouclé sur le limiteur-compresseur 3, et pour la bande-passante de filtre 2.

La figure 5 montre l'allure de la tension de sortie $V_S$ en fonction de la fréquence f avec un dispositif de correction 100 muni d'un filtre passe-bande 2 centré sur une fréquence fn, pour différentes valeurs décroissantes de la tension d'entrée $V_e$ (courbes 301 à 305). On remarque que pour des niveau de tension d'entrée élevés, supérieurs à la tension de seuil, le limiteur-compresseur 3 délivre un signal $V_L$ très faible par rapport à $V_e$, de sorte que le niveau de la tension de sortie $V_S$ n'est pratiquement pas modifié autour de la fréquence fn (courbe 301). En revanche lorsque le niveau de la tension d'entrée $V_e$ diminue, en entraînant une baisse générale du niveau de la tension de sortie $V_S$, le limiteur-compresseur 3 produit une atténuation moins forte dans la bande-passante du filtre 2 centrée sur la fréquence fn et la tension $V_L$ en sortie du limiteur-compresseur 3 représente une fraction d'autant plus élevée de la tension d'entrée $V_e$ que celle-ci est plus faible (courbes 302, 303, 304). Pour de très faibles niveau de la tension d'entrée $V_e$ (courbe 305), le signal de sortie est même ramené à zéro autour de la fréquence fn, la tension $V_L$ délivrée par le limiteur-compresseur 3 compensant totalement la tension d'entrée $V_e$.

On se référera maintenant à la figure 2 qui concerne un mode particulier de réalisation du circuit de corection 100 de la figure 1.

Le circuit limiteur-compresseur 3 est relié par un condensateur de liaison 21 au filtre passe-bande 2 dont l'entrée est reliée à la borne d'entrée 11 du circuit de correction 100. Lecircuit limiteur-compresseur 3 comprend un amplificateur opérationnel 30 dont l'entrée inverseuse est reliée d'une part à la masse, par une résistance 37 et d'autre part à la sortie de l'amplificateur opérationnel 30 par une résistance 38. L'entrée non inverseuse de l'amplificateur opérationnel 30 est elle-même reliée par une résistance 31 au condensateur de liaison 21 et par une résistance 33 à la masse. L'espace drain-source d'un transistor à effet de champ 34 du type V-MOS est connecté entre l'entrée non inverseuse de l'amplificateur opérationnel 30, qui reçoit les signaux issus du filtre 2, et la masse. La grille du transistor V-MOS 34 est elle-même reliée d'une part à la masse par un condensateur 36 et d'autre part par une résistance 35 au circuit 6 de détection de seuil et de constante de temps. Un condensateur 32 en parallèle sur la résistance 31 permet de réaliser une compensation de capacités parasites dues à la présence du transistor V-MOS 34.

La sortie 4 du circuit limiteur-compresseur 3 est reliée par un condensateur de liaison 41 à l'entrée non inverseuse d'un amplificateur opérationnel 50 qui constitue avec les résistances associées 51 à 54 un amplificateur linéaire 5 à gain ajustable. Une résistance 51 est connectée entre l'entrée non inverseuse de l'amplificateur opérationnel 50 et la masse tandis qu'une résistance 52 en série avec une résistance ajustable 53 est reliée entre l'entrée inverseuse de l'amplificateur opérationnel 50 et la masse. Une résistance 54 est connectée entre la sortie et l'entrée inverseuse de l'amplificateur opérationnel 50.

Le circuit 6 de détection de seuil connecté à la sortie de l'amplificateur linéaire 5 comprend un circuit redresseur doubleur de tension 61 à 65, un élément de référence de tension 67 et un circuit RC 68, 69 fournissant une constante de temps. Le circuit doubleur de tension comprend un amplificateur opérationnel 63 dont l'entrée non inverseuse est reliée à la masse, dont l'entrée inverseuse est reliée par une résistance 65 à la sortie de l'amplificateur linéaire 5, et dont la sortie est rebouclée sur l'entrée inverseuse par une résistance 64. La sortie de l'amplificateur opérationnel 63 est connectée à l'anode d'une diode 62 dont la cathode est connectée à la cathode d'une diode 61 dont l'anode reçoit les signaux de sortie de l'amplificateur linéaire 5. Les cathodes des diodes 61 et 62 sont reliées par une résistance 66 à la sortie 66A du circuit de détection de seuil 6 reliée par la résistance 35 à la grille du transistor V-MOS 34 pour commander le circuit limiteur-compresseur 3.

Au sein du circuit de détection de seuil 6, la référence de niveau de tension est donnée par une diode Zener 67 connectée entre le point 66A et la masse. Un circuit de constante de temps constitué du condensateur 69 en parallèle sur une résistance 68, est connecté en outre entre le point 66A et la masse. Ce circuit de constante de temps est adapté à la bande passante du filtre 2. Dans le cas d'un filtre 2 centré sur une fréquence élevée, la constante de temps introduite par le circuit RC 68, 69 est en effet plus petite que dans le cas d'un filtre 2 centré sur une fréquence basse correspondant aux graves, afin d'éviter un phénomène de pompage dans le circuit limiteur compresseur 3.

Le transistor V-MOS 34 du circuit limiteur compresseur 3 est maintenu bloqué par les circuits 5 et 6 lorsque le signal d'entrée $V_e$ est d'un niveau trop faible de sorte que le transistor V-MOS 34 est équivalent à une résistance de plusieurs mégohms et ne provoque pas d'atténuation du signal d'entrée dans le circuit limiteur 3.

Le signal disponible au point 4 peut alors être transmis par le pont diviseur 8 contitué d'une résistance 81 et d'une résistance ajustable 82 à l'entrée du circuit sommateur 9 reliée à la résistance 91. Le circuit sommateur 9 contribue alors à retrancher dans la bande-passante du filtre 2, une tension $V_L$ voisine de $V_e$ au signal d'entrée $V_e$ appliqué par le circuit inverseur 7 sur la deuxième entrée du circuit sommateur 9, ce qui réduit ainsi le bruit de fond.

En revanche, lorsque le signal $V_e$ contient un signal utile dépassant un seuil prédéterminé par les circuits 5 et 6, le transistor V-MOS 34 est rendu conducteur et joue le role de limiteur maintenant le signal de sortie de l'amplificateur opérationnel 30 à ladite valeur de seuil prédéterminé; de sorteque le signal appliqué à la résistance 91 du circuit sommateur 9 sert uniquement à masquer le bruit de fond résiduel tandis que le signal utile n'est pas altéré. pratiquement pas modifié par rapport au signal d'entrée $V_e$.

Le dispositif de correction selon l'invention permet d'améliorer fortement la dynamique d'une source audio ou vidéo. Ainsi, l'amplificateur à gain variable 5 peut être réglé par exemple de manière à avoir un gain compris entre 0 et 60 dB. Le limiteur compresseur peut lui-même avoir une plage d'action s'étendant à plus de 80 dB.

Par ailleurs, l'invention s'applique quelle que soit l'origine du bruit superposé au signal utile, que ce bruit provienne de l'enregistrement sur un support, par exemple magnétique, d'une transmission par voie hertzienne, ou du souffle de circuits électroniques situés en amont tels que des préamplificateurs.

## Revendications

1. Dispositif de réduction du bruit de fond dans une chaîne électroacoustique d'enregistrement ou de reproduction, caractérisé en ce qu'il comprend au moins un circuit de correction (100) interposé dans la chaîne électroacoustique et ccmportant un filtre passe-bande (2) recevant un signal d'entrée, ($V_e$), un circuit limiteur-compresseur (3) connecté en sortie du filtre passe-bande (2), un circuit (5,6) de détection de seuil connecté en sortie du circuit limiteur-compresseur (3) et rebouclé sur ledit circuit limiteur-compresseur (3) pour n'autoriser une compression par ledit circuit limiteur-compresseur (3) du signal issu du filtre passe-bande (2) que si le signal d'entrée ($V_e$) dépasse un seuil prédéterminé et un circuit sommateur-inverseur (9)auquel est appliqué d'une part le signal issu du circuit limiteur-compresseur (3) et d'autre part, par l'intermédiaire d'un circuit inverseur(7), le signal d'entrée ($V_e$) appliqué à l'entrée du filtre passe-bande (2).

2. Dispositif selon la revendication 1, caractérisé en ce qu'il comprend plusieurs circuits de correction (100) montés en cascade dans la chaîne électroacoustique et comprenant des filtres passe-bande(2) dont les bandes passantes sont différents mais ne se recoupent pas nécessairement.

3. Dispositif selon la revendication 1, caractérisé en ce que le circuit (5,6) de détection de seuil comprend un amplificateur linéaire à gain variable (5) connecté en sortie du circuit limiteur-compresseur (3) et un circuit de référence de tension(67).

4. Dispositif selon la revendication 3, caractérisé en ce que le circuit (5,6) de détection de seuil comprend en outre un circuit(68, 69) de retard pour effectuer la commande du circuit limiteur-compresseur(3) avec une constante de temps prédéterminée adaptée à la bande-passante du filtre (2).

5. Dispositif selon la revendication 3 ou la revendication 4, caractérisé en ce que le circuit (5,6) de détection de seuil comprend un circuit doubleur de tension (61 à 65) connecté en sortie de l'amplificateur linéaire à gain variable (5) et en ce que le circuit de référence de tension (67) comprend au moins une diode Zener.

6. Dispositif selon l'une quelconque des revendications 1 à 5, caractérise en ce que le circuit limiteur-compresseur(3) comprend un amplificateur opérationnel (30) et un transistor à effet de champ V-MOS (34) commandé par le circuit (5,6) de détection de seuil pour court-circuiter sélectivement l'entrée de l'amplificateur opérationnel(30) lorsque le circuit (5,6) de détection de seuil détecte le dépassement d'un seuil prédéterminé de tension.

7. Dispositif selon l'une quelconque des revendications 1 à 6, caractérisé en ce que le circuit limiteur-compresseur (3) comprend un moyen (8) de réglage de la tension de sortie dudit circuit limiteur-compresseur (3) appliquée au circuit sommateur (9).

8. Dispositif selon le revendication 2, caractérisé en ce que les bandes passantes des filtres passe-bande (2) des circuits de correction (100) montés successivement en cascade sont croissantes.

## Claims

1. A noise reduction device in an electroacoustic recording and reproducing system, characterized in that it comprises at least one correction circuit (100) interposed in the electroacoustic system and comprising a band-pass filter (2) receiving an input signal (Ve), a compressor limiter circuit (3) connected to the output of the band-pass filter (2), a threshold detector circuit (5,6) connected to the output of the compressor-limiter circuit (3) and looped thereon in order to allow compression, by said compressor limiter circuit (3), of the signal issued from the band-pass filter (2), only if the input signal (Ve) exceeds a predetermined threshold, and a summing-inverter circuit (9) to which is applied, on the one hand, the signal issued from said compressor limiter circuit (3), and on the other hand, via an inverter circuit (7), the input signal (Ve) applied to the input of the band-pass filter (2).

2. A device as claimed in Claim 1, characterized in that it comprises a plurality of correction circuits (100) cascade-mounted in the electroacoustic system and comprising band-pass filters (2), the pass-bands of which are different but do not necessarily overlap.

3. A device as claimed in Claim 1, characterized in that the threshold detector circuit (5,6) comprises a variable gain linear amplifier (5) connected to the output of the compressor limiter circuit (3), and a voltage reference circuit (67).

4. A device as claimed in Claim 3, characterized in that the threshold detector circuit (5, 6) further comprises a delay circuit (68, 69) controlling the compressor limiter circuit (3), with a predetermined time constant adapted to the pass-band of the filter (2).

5. A device as claimed in Claim 3 or Claim 4, characterized in that the threshold detector circuit (5, 6) comprises a voltage doubler circuit (61 to 65) connected to the output of the variable gain linear amplifier (5) and the voltage reference circuit (67) comprises at least one Zener diode.

6. A device as claimed in anyone of Claims 1 to 5, characterized in that the compressor-limiter circuit (3) comprises an operational amplifier (30) and a V-MOS field effect transistor (34) controlled by the threshold detector circuit (5, 6) for selectively short-circuiting the input to the operational amplifier (30) when the threshold detector circuit (5, 6) detects that a predetermined voltage threshold has been exceeded.

7. A device as claimed in anyone of Claims 1 to 6, characterized in that the compressor-limiter circuit (3) comprises means (8) for adjusting the output voltage of said compressor-limiter circuit (3) which is applied to the summing circuit (9).

8. A device as claimed in Claim 2, characterized in that the pass-bands of the band-pass filters (2) of the correction circuits (100) successively mounted in cascade, are increasing.

## Ansprüche

1. Rauschunterdrückungsvorrichtung in einer elektroakustischen Wandlerkette zur Aufnahme oder Wiedergabe, dadurch gekennzeichnet, daß sie zumindest einen Korrekturkreis (100) aufweist, der in der elektroakustischen Kette vorgesehen ist, und ein Bandpaßfilter (2), das ein Eingangssignal (Ve) erhält, weiters einen BegrenzerKompressorkreis (3), der am Ausgang des Bandpaßfilters (2) angehängt ist, einen Schrankendetektorkreis (5, 6), der am Ausgang des Begrenzer-Kompressorkreises (3) angehängt ist und auf den Begrenzer-Kompressorkreis (3) zurückgeführt wird, um eine Kompression des vom Bandpaßfilter (2) kommenden Signales durch den Begrenzer-Kompressorkreis (3) nur dann zu gestatten, wenn das Eingangssignal (Ve) eine vorbestimmte Schranke überschreitet und einem Spitzeninversorkreis (9), auf den einerseits das vom Begrenzerkompressorkreis (3) kommende Signal und andererseits über einen Inversorkreis (7) das Eingangssignal (Ve), das am Eingang des Bandpaßfilters (2) anliegt, eingegeben wird.

2. Vorrichtung nach Anspruch 1, dadurch gekennzeichnet, daß sie mehrere Korrekturkreise (100) in Kaskadenschaltung in der elektroakustischen Kette aufweist und dass die Korrekturkreise (100) Bandpassfilter (2) enthalten, deren Durchgangsbänder unterschiedlich sind, sich aber nicht notwendigerweise überschneiden.

3. Vorrichtung nach Anspruch 1, dadurch gekennzeichnet, daß der Schrankendetektorkreis (5, 6) einen Linearverstärker mit variabler Verstärkung aufweist, der am Ausgang des Begrenzer-Kompressorkreises (3) und einem Referenzspannungskreis (67) anliegt.

4. Vorrichtung nach Anspruch 3, dadurch gekennzeichnet, daß der Schrankendetektorkreis (5, 6) darüberhinaus einen Verzögerungskreis (68, 69) aufweist, um den Begrenzer-Kompressorkreis (3) mit einer vorbestimmten, an das Bandpaßfilter (2) adaptierten Zeitkonstante zu regeln.

5. Vorrichtung nach Anspruch 3 oder 4, dadurch gekennzeichnet, daß der Schrankendetektorkreis (5, 6) einen Spannungsverdopplungskreis (61 bis 65) aufweist, der am Ausgang des linearen Verstärkers mit regelbarer Verstärkung (5) liegt und dadurch, daß der Referenzspannungskreis (67) zumindest eine zenerdiode aufweist.

6. Vorrichtung nach einem der Ansprüche 1 bis 5, dadurch gekennzeichnet, daß der Begrenzer-Kompressorkreis (3) einen Operationsverstärker (30) und einen Feldeffekttransistor V-MOS (34) aufweist, der durch den Schrankendetektorkreis (5, 6) betätigt wird, um selektiv den Eingang des Operationsverstärkers (30) kurz zu schließen, wenn der Schrankendetektorkreis (5, 6) das Überschreiten in einer vorbestimmten Spannungsschranke feststellt.

7. Vorrichtung nach einem der Ansprüche 1 bis 6, dadurch gekennzeichnet, daß der Begrenzer-Kompressorkreis (3) ein Mittel (8) für die Regelung der Ausgangsspannung des Begrenzer-Kompressorkreises (3), die auf den Summierkreis (9) angelegt wird, aufweist.

8. Vorrichtung nach Anspruch 2, dadurch gekennzeichnet, daß die Durchgangsbereiche der Bandpaßfilter (2) der Korrekturkreise (100), die aufeinanderfolgend in Kaskadenschaltung angeordnet sind, grösser werden.

Fig.1

EP 0 248 713 B1

Fig.2

Fig.3

Fig.4

Fig.5